(19) Europäisches Patentamt
European Patent Office
Office européen des brevets

(11) **EP 2 753 898 B1**

(12) **EUROPÄISCHE PATENTSCHRIFT**

(45) Veröffentlichungstag und Bekanntmachung des Hinweises auf die Patenterteilung:
**31.08.2016 Patentblatt 2016/35**

(21) Anmeldenummer: **12753996.3**

(22) Anmeldetag: **04.09.2012**

(51) Int Cl.:
*G01B 11/14* (2006.01)    *G01C 3/08* (2006.01)
*G01S 7/484* (2006.01)    *G01S 17/10* (2006.01)
*H01S 5/042* (2006.01)    *H01S 5/068* (2006.01)
*H03K 3/57* (2006.01)

(86) Internationale Anmeldenummer:
**PCT/EP2012/067229**

(87) Internationale Veröffentlichungsnummer:
**WO 2013/034555 (14.03.2013 Gazette 2013/11)**

(54) **ELEKTROOPTISCHER DISTANZMESSER**

ELECTRO-OPTICAL DISTANCE-MEASURING DEVICE

DISPOSITIF DE MESURE DE DISTANCE ÉLECTRO-OPTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **06.09.2011 EP 11180282**

(43) Veröffentlichungstag der Anmeldung:
**16.07.2014 Patentblatt 2014/29**

(73) Patentinhaber: **Leica Geosystems AG
9435 Heerbrugg (CH)**

(72) Erfinder:
• **METZLER, Reto
CH-9445 Rebstein (CH)**
• **FIEGL, Bernhard
CH-9437 Marbach (CH)**
• **GIGER, Kurt
9464 Rüthi (CH)**

(74) Vertreter: **Gyaja, Christoph Benjamin
Kaminski Harmann
Patentanwälte AG
Landstrasse 124
9490 Vaduz (LI)**

(56) Entgegenhaltungen:
**EP-B1- 1 311 873      DE-A1- 19 546 563
JP-A- 7 079 042      JP-A- 2008 227 408
US-B1- 7 184 130**

**Beschreibung**

Die Erfindung betrifft einen elektrooptischen Distanzmesser mit einem sicheren Lasertreiber und ein ein Verfahren zur Erzeugung eines Laserpulses mittels einer Laserdiode in einem elektrooptischen Distanzmesser.

Die allgemeinen Richtlinien zur Lasersicherheit (beispielsweise nach EN 60825, ANSI Z136 oder entsprechend der "International Commission on Non-Ionizing Radiation Protection") verlangen, dass eine Laserlichtquelle nur derart betrieben werden darf, dass von ihr keine Gefahren ausgehen. Dabei sind - abhängig von der emittierten Wellenlänge - Grenzwerte der thermischen Leistungsdichte bzw. der Energiedichte einzuhalten. Die Augensicherheit ist bei Lasergeräten von primärer Bedeutung, da das Auge funktionsbedingt am empfindlichsten auf elektromagnetische Strahlung reagiert und durch direkte, indirekte oder gestreute Laserstrahlen Schädigungen der Netzhaut oder Hornhaut auftreten können. Dies gilt insbesondere, da Studien zeigten, dass auch bei sichtbarem Licht vom Lidschlussreflex zum Schutz des Auges im Regelfall nicht ausgegangen werden kann. Lasergeräte sind entsprechend dieser Vorschriften zu klassifizieren und entsprechend zu kennzeichnen, was gegebenenfalls auch eine Sicherheits-Prüfung und Zertifizierung umfassen kann.

Bei einer Vielzahl von Laser-Geräte, beispielsweise elektrooptischen Vermessungsgeräten wie Laser-Distanzmesser oder Laser-Nivellierer, Laser-Projektor, Laser-Scanner, etc. ist funktionsbedingt ein Austritt des Laserlichts aus dem Gehäuse des Geräts zwingend erforderlich. Auch ist oftmals funktionsbedingt eine optische Mindestenergie erforderlich, welche über der Ungefährlichkeitsgrenze läge, wenn diese im Dauerstrichbetrieb emittieren würde. Daher werden die Laser in derartigen Geräten meist gepulst betrieben. Um die Augensicherheit zu garantieren, müssen die Laserquellen mit entsprechenden Schutzmaßnahmen ausgestattet sein, um die geltenden Normen und Vorschriften zu erfüllen. Dies gilt nicht nur im gewöhnlichen Betriebsfall, sondern auch unter so genannten "Einfehlerbedingungen", welche all jene Fehlerszenarien abdecken, bei welchen ein einziger Fehler für sich alleine auftritt (z.B. Versagen einzelner Bauteile, Kurzschluss, Leiterbahnbruch, etc.). Dabei muss beispielsweise auch bei Ausfall einer beliebigen Komponente sichergestellt werden, dass trotz auftreten eines solchen Einfachfehlers, die austretende Laserleitung innerhalb von Sekundenbruchteilen unter die obere Leistungsgrenze der entsprechenden Laserklasse abfällt, um Augenschäden auszuschließen. Bei Pulsbetrieb ist durch spezielle Maßnahmen darauf zu achten, das eine andauernde Emission mit den - über den Grenzwerten liegenden - Puls-Spitzenwerten auch im Fehlerfall ausgeschlossen werden kann. Derartige Single-Fault-Tests sind vom Hersteller des Lasergeräts entsprechend durchzuführen und nachzuweisen.

Je nach Laserklasse und Anwendungsfall kann auch weitergehend eine Zwei- oder Mehrfehlersicherheit gefordert sein, bei welcher auch bei gleichzeitigem Auftreten von mehr als einem Fehler ein Nachweis der Sicherheit zu erbringen ist, dass die emittierte Laserleitung keinesfalls die Grenzwerte überschreitet und somit eine Gefährdung des Benutzers ausgeschlossen werden kann. Die in diesem Dokument beschriebene Einfehlersicherheit stellt auch in diesen Fällen eine jedenfalls zu erfüllende Basisvoraussetzung dar, welche durch entsprechende, weiterführende Maßnahmen ausgebaut werden kann.

Die zur Herstellung der Lasersicherheit gebräuchliche Lösung ist die direkte Überwachung der emittierten Laserleistung mit Hilfe einer Monitordiode. Dabei wird ein Teil des emittierten Laserlichts auf ein photosensitives Element geleitet, beispielsweise eine Photodiode oder ein Phototransistor, welches ein lichtintensitätsabhängiges elektrisches Signal bereitstellt. Eine Überwachungsschaltung, beispielsweise in Form eines Mikrokontrollers oder eines (bei sicherheitsrelevanten Schaltungsteilen gegebenenfalls sogar vorgeschriebenen) diskreten Schaltkreises, kann somit die aktuell emittierte Laserleistung überwachen und gegebenenfalls bei Überschreitung eines Grenzwertes der emittierten Laserenergie bzw. Laserleistung den Laser abschalten.

Beispielsweise zeigen die Dokumente EP 0 314 390, US 5,287,375, EP 0 780 937, EP 0 664 591 oder EP 0 597 644 unterschiedlichste Lasertreiberschaltungen, welche alle eine Überwachungsschaltung mit einer Monitordiode aufweisen, welche mit einem Teil des von der Laserdiode emittierte Lichtes beaufschlagt wird und mit deren Hilfe die aktuelle Ausgangsleistung der Laserdiode bestimmbar ist. Im Fehlerfall, beispielsweise bei einem Kurzschluss eines Leistungstransistors der Endstufe der Laserdiodenansteuerung, kann aufgrund dieser Information die elektrische Energiezufuhr zur Laserdiode - mittels einem entsprechend ausgelegten Sicherheitskreis - reduziert bzw. unterbunden werden.

Aufgrund der Allgemeinheit der Lasersicherheitsvorschriften bzw. auch aufgrund einer oft anwendungsbedingt erforderlichen Regelung der Ausgangsleistung der Laserdiode, sind eine Vielzahl der kommerziell erhältlichen Laserdioden-Bauelemente bereits mit einer entsprechenden Monitordiode ausgestattet. Laserdioden weisen zudem oft starke Exemplarstreuungen, Temperaturabhängigkeiten oder Alterungseffekte auf, welche durch Bestimmung der tatsächlichen optischen Ausgangsleistung ausgeglichen werden können. Der schaltungstechnische Aufwand einer derartigen Überwachung ist recht hoch und auch entsprechend kostenintensiv. Es bleibt somit der Aufwand, das analoge und oft störungsempfindliche Signal des - vielfach als Photodiode ausgeführten - photosensitiven Überwachungselements auszuwerten. Vielfach muss eine derartige Sicherheitsschaltung auch in einer entsprechend nachweislich sicheren und zertifizierbaren Weise ausgeführt werden, was den Schaltungsaufwand zusätzlich erhöhen kann, insbesondere da die Realisierung von sicherheitsrelevanten Schaltungsteilen oft an strenge Bedingungen und Dokumentationsvorschriften geknüpft ist.

Zudem ist im Pulsbetrieb von Laserdioden, bei welchem nur sehr kurze Lichtimpulse mit einer hohen Spitzenleitung ausgesendet werden, bedingt durch die dabei in der elektronischen Schaltung auftretenden, steilen Schaltflanken und hohen Spitzenströmen, mit entsprechenden elektromagnetischen Störsignalen (Übersprechen, etc.) zu rechnen, welche die (meist hochohmige erfolgende) Auswertung der Messsignale einer Monitordiode stören und erschweren können. Auch kann die kurze Pulsdauer des emittierten Lichtes und der korrespondierenden Monitor-Signale eine Überwachung der tatsächlich emittierten, mittleren Lichtenergie erschweren.

Die Laserpulse werden dabei vielfach in Paketen von Pulsen, den so genannten "Bursts" emittiert, wie diese etwa in EP 01 957 668 beschrieben ist. Dabei folgt nach einem Paket mit einer Anzahl von schnell hintereinander folgenden, kurzen Laserimpulsen eine Todzeit in welcher keine Laseremission stattfindet und welche deutlich länger als die Pausen zwischen den Pulsen innerhalb des Paketes ist.

JP 7 079042 zeigt die Anwendung eines Pulsformungsnetzwerks um eine Laserdiode mit einem Stromimpuls zu versorgen, welcher keine Störungen aufweist.

JP 2008 227408 beschreibt eine energieeffiziente Erhöhung einer DC-Spannung mittels eines Hochsetzstellers zur Versorgung einer Serienschaltung von mehreren Leuchtdioden bzw. Laserdioden deren Flussspannung die DC-Spannung übersteigt.

US 7 184 130 offenbart einen augensicheren Laserentfernungsmesser der eine Serie von Laserpulsen emittiert. Eine Batterie liefert Strom durch einen Induktor zu einem Kondensator und einer Laserdiode. Während ein MOSFET Schaltelement angeschaltet ist, baut sich ein Strom im Induktor auf. Bei Schließen des MOSFETs wird die im Induktor enthaltene Energie zum Kondensator transferiert der dadurch auf eine hohe Spannung geladen wird. Beim erneuten Anschalten des MOSFETs wird der Kondensator abrupt über die Laserdiode entladen, wobei ein kurzer, sehr hoher Strompuls durch die Laserdiode erzeugt wird.

Es ist daher eine Aufgabe der vorliegenden Erfindung die Ansteuerung einer Laserdiode, insbesondere unter Einhaltung der Sicherheitsvorschriften, zu verbessern.

Eine Aufgabe besteht auch darin, einen sicheren Lasertreiber für den Puls- oder Burst-Betrieb bereitzustellen, welcher einfacher und kostengünstiger realisierbar ist und beispielsweise einen geringern Bauteil- und Auswerteaufwand aufweist.

Eine Teilaufgabe ist dabei auch einen Lasertreiber bereitzustellen, welcher in hochintegrierter Form herstellbar ist, neben einem klassischen Leiterplattenaufbau also beispielsweise auch in Dickschichttechnik, Dünnschichttechnik oder als ASIC.

Eine Aufgabe ist auch die Lasersicherheit mit einer Schaltung zu erzielen, bei welcher im Sicherheitskreis keine analogen Monitorsignale eines photosensitiven Elements ausgewertet werden, insbesondere bei welcher keine Analog-zu-Digital Wandlung (ADC) notwendig ist.

Eine Teilaufgabe ist auch die sicherheitsgerechte Ansteuerung einer Laserdiode, welche weniger elektrische Anschlüsse aufweist als eine mit einer Monitordiode ausgestattete Laserdiode, insbesondere einer zweipoligen Laserdiode in SMD-Bauform.

Auch die Entwicklung einer einfehlersicheren Lasertreiberschaltung welche ohne Monitordiode auskommt, ist eine Aufgabe der vorliegenden Erfindung.

Ebenso das Bereitstellen eines Lasertreibers als ASIC, insbesondere mit einem rein digitalen Interface nach aussen, ist eine Aufgabe der vorliegenden Erfindung.

Ein erfindungsgemäßer elektrooptischer Distanzmesser wird in Anspruch 1 und ein erfindungsgemäßes Verfahren in Anspruch 10 angegeben. Weitere Ausführungsbeispiele der Erfindung sind Gegenstand der abhängigen Ansprüche.

Im Weiteren beschrieben wird ein erfindungsgemäßer elektrooptischer Distanzmesser zur Emission von Laserlichtpulsen mit einem sicheren Lasertreiber für eine Laserdiode mit einer Laserdioden-Spannungversorgung, zur Bereitstellung einer Spannung welche Unterhalb einer Laser-Threshold-Spannung der Laserdiode liegt. Dadurch ist bei statischem Anliegen der Spannung an der Laserdiode kein Laserlicht emittierbar.

Der Lasertreiber hat weiters eine induktive Komponente in einem Versorgungspfad der Laserdiode, insbesondere elektrisch verbunden mit der Laserdiode, und ein elektronisches Schaltelement.

Das Schaltelement ist dabei derart zusammenwirkend angeordnet, dass in einer ersten statischen Schaltstellung des Schaltelements ein Stromfluss durch die induktive Komponente erzeugbar ist und in einer zweiten statischen Schaltstellung des Schaltelements der Stromfluss durch die Laserdiode leitbar ist. Im Speziellen mit der induktiven Komponente im Schaltkreis zwischen der Spannungsversorgung und der Laserdiode liegend und insbesondere mit einem zur Laserdiode elektrisch parallelgeschalteten Schaltelement.

Lediglich bei einem Wechsel von der ersten zur zweiten Schaltstellung ist einer der Laserlichtpulse emittierbar.

Ein einzelner der somit bei einem Wechsel von der ersten zur zweiten Schaltstellung emittierbaren Laserlichtpulse weist eine Energie auf, welche durch die in der induktiven Komponente aufgrund des Stromflusses gespeicherte Energie begrenzt ist und auch die mittlere emittierte Laserleistung einer Gruppe der Laserlichtpulse ist somit begrenzt ist.

Insbesondere kann der Lasertreiber somit einen monitordiodenlosen Sicherheitskreis zur Einhaltung einer maximal zulässigen mittleren Laserleistung aufweisen.

Mit einem monitordiodenlosen Sicherheitskreis kann somit die Einhaltung einer maximal zulässigen Emissionsleistung, entsprechend der Lasersicherheitsrichtlinien gewährleistet werden, im Speziellen auch im Einfehlerfall, beispielsweise bei Ausfall oder Kurzschluss einer Komponente oder eines Bauelements des Lasertreibers.

Eine Grundidee der vorliegenden Erfindung ist, dass die DC Vorwärtsspannung mit welcher die Laserdiode versorgt wird, unterhalb der Laserschwelle, des sogenannten Laserthresholds der Laserdiode liegt. Dies bedeutet, dass die Laserdiode im Gleichstromfall kein Laserlicht emittieren kann. Selbst bei direktem Anlegen der Versorgung zur Laserdiode (z.B. bei einem Kurzschluss), tritt keine stimulierte oder verstärkte Emission auf, sondern allenfalls nur eine schwache, spontane, nichtverstärkte Emission von Photonen, ähnlich einer Leuchtdiode. Somit ist in diesem Betriebs- bzw. Fehler-Zustand die Lasersicherheit gewährleistet.

Um im Pulsbetrieb dennoch Laserlicht emittieren zu können, befindet sich in einer zur Erläuterung herangezogenen, beispielhaften Ausführungsform in Serie zur Laserdiode eine induktiv wirkende Komponente und parallel zur Laserdiode ein Schaltelement, mit welchem die Laserdiode kurzgeschlossen werden kann. Der Ablauf zur Emission eines Laserpulses ist dabei wie folgt:

1. Ein Puls-Generator schließt den Schalter parallel zur Laserdiode. Dadurch liegt die Versorgungsspannung (welche wie beschrieben unterhalb des Laserthresholds liegt) an der induktiven Komponente an.

2. Es prägt sich ein Strom in der induktiven Komponente ein. Dieser fließt von der Spannungsquelle über die induktive Komponente und den Schalter nach Maße.

3. Der Puls-Generator öffnet den Schalter.

4. Da der Strom in der induktiven Komponente trotz offenem Schalter aber weiterhin bestehen bleibt, muss dieser nun durch die Laserdiode fließen. Es hebt sich das Potential an der Anode der Laserdiode über den Laserthreshold und die stimulierte Emission eines Laserpulses setzt ein. Die maximale Energie des Pulses ist dabei aber von der in der induktiven Komponente gespeicherten Energie beschränkt. Wenn sich der Strom abgebaut hat und die Spannung an der Anode der Laserdiode unter die Laserthreshold-Spannung gesunken ist, ist auch die Laser-Emission zu Ende.

5. Der Prozess kann sich bei Schritt 1 wiederholen.

Die Laserpulse können somit als einzelne Pulse oder in Puls-Paketen (Bursts) oder als kontinuierliche Pulsfolge abgegeben werden. Zwischen den Pulsen oder Bursts kann der Schalter geschlossen oder offen bleiben. In beiden Fällen wird der Laser kein Licht abgeben.

Ist der Schalter offen, so baut sich ein allfälliger Strom in der induktiven Komponente über die Laserdiode ab und die Spannung über der Laserdiode fällt unter den Threshold (etwa auf das Niveau der Versorgungsspannung) ab. Da die Versorgungsspannung unter der Threshold-Spannung liegt, wird bei statisch offenem Schalter kein Laserlicht erzeugt. Somit ist in diesem statischen Betriebszustand keine Laseremission möglich.

Ist der Schalter geschlossen, so fließt der Strom durch den Schalter und nicht durch die Laserdiode, wodurch in diesem statischen Betriebszustand ebenfalls keine Laseremission möglich ist. Die Laserdiode ist durch den Schalter kurzgeschlossen - somit sind die Spannung und der Strom an der Laserdiode annähernd Null, jedenfalls unter den Thresholdwerten.

Lediglich bei einem Wechsel von geschlossenem zu offenem Schalter ist eine Emission der Laserdiode möglich, aber auch hier mit einer definierten Obergrenze der möglichen Pulsenergie. Keinesfalls ist eine Dauerstrichemission von Laserlicht möglich.

Die Laserleistung kann über die Anzahl Pulse pro Burst oder der Pulswiederholrate innerhalb des Burst eingestellt werden. Beispielsweise kann dies in der Produktion des Lasers oder assemblierten Lasergerätes im Rahmen einer Funktionsprüfung oder Kalibrierung ermittelt und eingestellt werden. Auch mittels einer Justierung des Tastverhältnisses des Pulsgenerators bei der Pulsgeneration kann die Energie eines Einzelpulses beeinflusst werden. Beispielsweise kann die Pulsenergie auch über die Zeitdauern der beiden Schaltzustände beim "Laden" bzw. "Entladen" der Induktivität beeinflusst werden. Es kann jedoch eine maximale Einzelpulsenergie nicht überschritten werden, welche sich aus dem Maximalstrom bei statisch geschlossenem Schalter und der damit verbundenen, in der Induktivität gespeicherten, Energiemenge bestimmt. Wenn beispielsweise die Parameter des Pulsgenerators anhand eines Schlimmstfall-Szenarios begrenzt werden, kann ein Überschreiten der Lasersicherheitsgrenzen in jedem Fall ausgeschlossen werden. Somit kann der Lasertreiber derart ausgelegt werden, dass in jedem Fall die Lasersicherheit garantiert werden kann.

Alterungseffekte machen den Laser lediglich ineffizienter, somit wird die Laserleistung mit der Zeit leicht abnehmen, aber auf keinen Fall die bei der Produktion eingestellte Grenze überschreiten. Ein altersbedingter Leistungsabfall könnte - falls notwendig - auch durch eine erneutes bestimmen der tatsächlich emittierten Leistung und Justage der Puls- bzw. Burst-Parameter kompensiert werden.

Die Versorgungsspannung des Lasertreibers bzw. des gesamten Systems kann sehr wohl über der Laserthreshold-Spannung liegen.

Dadurch wird beispielsweise eine Versorgung der peripheren Logikschaltungen, Prozessoren, Kommunikationsbausteine, etc. mit den hierfür gebräuchlichen, oft über der Laserschwelle liegenden Spannungen zu ermöglicht. Ein Tiefsetzsteller oder Längsregler (LDO) kann in diesem Falle die Laserdiode bzw. die davor geschaltete induktive Komponente, mit einer entsprechend niedrigeren, von der Versorgung unabhängigen geregelten Spannung versorgen, welche unter der Laserthreshold-Spannung liegt. Der Lasertreiber kann hierbei auch in Form eines ASICs ausgeführt sein, wobei der LDO sowohl extern angeordnet, als auch direkt im ASIC integriert sein kann.

Bei einer solchen Ausführung, bei welcher Spannungen über dem Laserthreshold im oder um den Lasertreiber vorhanden sind, ist jedoch ein zusätzlicher Fehlerfall möglich, bei welchem die Sicherheit rein auf Basis der oben erläuterten, erfindungsgemäßen Schaltung bzw. Methode nicht mehr gewährleistet wäre, nämlich einen Kurzschluss zwischen der höheren Versorgung und einem elektrischen Netz in der Versorgung der Laserdiode.

Ein derartiger Kurzschluss kann durch eine zusätzliche Überwachung der Laserdiodenversorgungsspannung erkannt werden. Beispielsweise kann dies durch eine Kurzschluss-Detektionsschaltung (SCD) erkannt werden und mittels eines digitalen Signals an einen übergeordneten Mikrokontroller signalisiert oder direkt einer Sicherheitsabschaltung zugeführt werden. Die SCD kann dabei beispielsweise auch direkt in den LDO und/oder den Lasertreiber integriert sein, im Spezielle könnte etwa die am LDO auftretende Regelabweichung zum feststellen einer Überspannung herangezogen werden. Dieser kann im Fehlerfall die nunmehr zu hohe Vorwärtsspannung mittels eines zusätzlichen (unabhängigen) Schaltelements von der induktiven Komponente und/oder der Laserdiode trennen. Alternative kann durch das zusätzliche Schaltelement auch der ganze Lasertreiber von der - über dem Laserthreshold liegenden - Versorgungsspannung getrennt werden. Gegebenenfalls ist dabei eine zusätzliche Sicherungseinrichtung gegen automatisches Wiedereinschalten vorzusehen.

Alternativ kann die Laserdiodenversorgungsspannung auch durch eine Spannungsmessung, eine Komparatorschaltung oder dergleichen überwacht werden. Auch bezüglich der zusätzlichen Abschaltung im Fehlerfall gibt es funktionell äquivalente Alternativlösungen, mit welchen ebenfalls die geforderten Sicherheitsbedingungen erfüllt werden können.

Das erfindungsgemäße Verfahren und die erfindungsgemäße Vorrichtung werden nachfolgend anhand von konkreten Ausführungsbeispielen, welche in den Zeichnungen schematisch dargestellt sind, rein beispielhaft näher beschrieben. Dabei wird auch auf weitere Vorteile der Erfindung eingegangen. Im Einzelnen zeigen:

Fig. 1 ein Schema einer im Stand der Technik gebräuchlichen Laserdiode mit einer Monitordiode zur Sicherstellung bzw. Überwachung der Lasersicherheit;

Fig. 2 ein Elektronik-Schema eines Lasertreibers zur Erläuterung des Grundprinzips;

Fig. 3 ein beispielhaftes Ablaufschema einer Laserpulserzeugung;

Fig. 4 ein Diagramm eines beispielhaften Strom-Spannungsverlaufs bei einem Lasertreiber.

Fig. 5a ein beispielhaftes Elektronik-Schema eines zweiten Lasertreibers mit einer Versorgungsspannungsüberwachung;

Fig. 5b ein Elektronik-Schema einer ersten beispielhaften alternativen Anordnung der Komponenten in einem Lasertreiber;

Fig. 5c ein Elektronik-Schema einer zweiten beispielhaften alternativen Anordnung der Komponenten in einem Lasertreiber;

Fig. 6 ein beispielhaftes Blockschaltbild einer ersten Ausführungsform eines erfindungsgemässen Lasertreibers in grösserem Kontext;

Fig. 7 ein beispielhaftes Blockschaltbild einer zweiten Ausführungsform eines erfindungsgemässen Lasertreibers mit alternativer Überspannungs-Abschaltung;

Fig. 8 ein beispielhaftes Blockschaltbild einer dritten Ausführungsform eines erfindungsgemässen Lasertreibers mit alternativer Überspannungs-Abschaltung und einem Pulsformungs-Netzwerk;

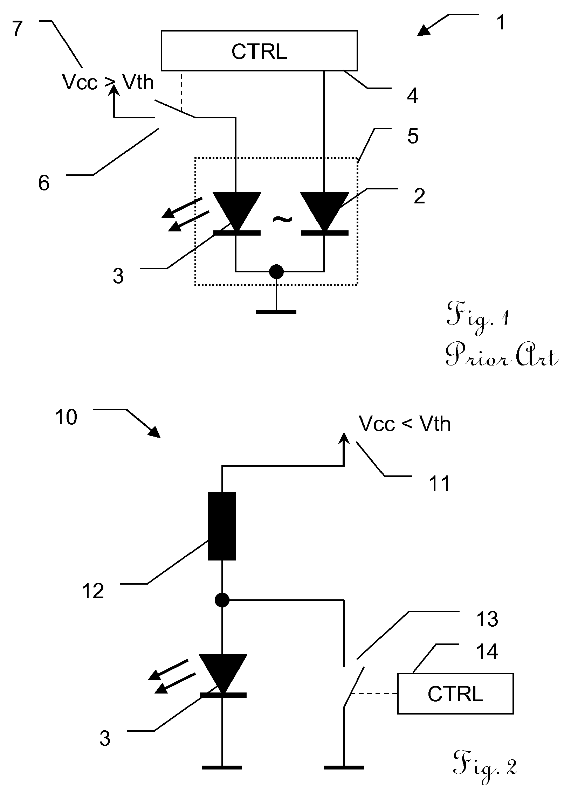

In Fig. 1 ist ein aus dem Stand der Technik bekannter Lasertreiber 1 mit Sicherheitsüberwachung dargestellt, bei welchem von einem Sicherheits-Controller 4 mit Hilfe einer Montitordiode 2, die von der Laserdiode 3 emittierte Laserleistung überwacht wird. Im Falle einer Überschreitung der in den Regulatorien festgelegten Limiten, wird eine weiterführende Energieversorgung der Laserdiode 3, beispielsweise durch Öffnen des Schalters 6, unterbunden. Vielfach ist dabei die Monitordiode 2 bereits von Laserdiodenhersteller in demselben Gehäuse 5 wie die Laserdiode 3 untergebracht (wobei auch andere Ausgangsverschaltungen der beiden Elemente als hier dargestellt üblich sind). Um Laserlicht emittieren zu können ist eine Versorgungsspannung 7 (Vcc) größer als die Laserschwellen-Spannung (Vth) des Lasers 3 erforderlich, welche zur Emission eines Pulses für die gewünschte Pulsdauer an die Laserdiode angelegt wird.

Zur Überwachung durch den Sicherheits-Controller 4 muss das analoge Ausgangssignal der Photodiode 2 ausgewertet werden und gegebenenfalls bei überschreiten der Sicherheitsgrenzen eine Abschaltung erfolgen. Beispielsweise kann die Abschaltung durch Trennen der Versorgung mittels des Schalters 6 erfolgen, welcher vorteilhaft eine zweite, unabhängige Instanz zu jener Schaltung darstellt, welche die Laserpulse generiert. Da dieser Schaltungsteil sicherheitsrelevant ist, können gewisse Designvorschriften gelten, beispielsweise kann eine reine Softwarelösung von sicherheitsrelevanten Teilen unzulässig oder zumindest strengen Designvorschriften unterworfen sein.

Fig. 2 zeigt einen sicheren Lasertreiber 10 für einen Pulsbetrieb einer Laserdiode, bei welchem in Bezug auf die Einfachfehler-Lasersicherheit auf eine Monitordiode verzichtet werden kann.

Wie bereits zuvor erläutert, ist dabei die Versorgungsspannung 11 (Vcc) der Laserdiode 3 derart ausgelegt, dass diese die Laserschwellen-Spannung (Vth) der Laserdiode 3 nicht übersteigt. Die Laserschwellen-Spannung Vth ist jene Spannung, welche über der Laserdiode 3 abfällt, und bei der die Besetzungsinversion im Halbleiter gerade derart hoch ist, dass eine stimulierte Emission (oder das "Lasern") beginnt. Alternativ zur Threshold-Spannung ist in Datenblättern gegebenenfalls auch ein Laser-Threshold-Strom angegeben, woraus der Fachmann jedoch in bekannter Weise die zur Einprägung dieses Stromes notwendige - und somit limitierende - Spannung bestimmen kann.

Die Laserdiode 3 ist in dieser Ausführungsform mit ihrer Kathode auf Null-Potential GND und mit ihrer Anode über eine induktive Komponente 12 mit der Versorgungsspannung 11 verbunden. Da die Versorgungsspannung 11 zu niedrig ist um eine stimulierte Emission auszulösen, kann die Laserdiode maximal ein durch spontane Emission erzeugtes Leuchten abgeben, dessen Intensität jedenfalls unterhalb der zulässigen Grenzwerte liegt, insbesondere da es sich bei einer derartigen Emission auch nicht um "Laserlicht" im eigentlichen Sinne handelt. Es ist offensichtlich, dass die Anordnung der Komponenten in funktionell äquivalenter Weise auch anders, (beispielsweise horizontal gespiegelt mit der Induktivität auf der Kathodenseite, etc.) ausgeführt werden könnte.

Ist das Schaltelement 13 (welches beispielsweise als Transistor ausgeführt sein kann, speziell als Feldeffekttransistor) geschlossen, kann die Laserdiode 3 ebenfalls kein Laserlicht emittieren. Die Laserdiode ist vom Schalter kurzgeschlossen, weshalb der Strom über den Schalter und nicht über die Laserdiode 3 fließt.

Ein weiterer vorteilhafter Nebeneffekt kann dabei auch sein, dass der Laser beispielsweise direkt an einer Batteriespannung unterhalb des Laserthresholds betrieben werden kann, ohne dass diese Spannung erst mittels eines eigens dafür nötigen Hochsetzstellers über den Threshold-Pegel angehoben werden muss.

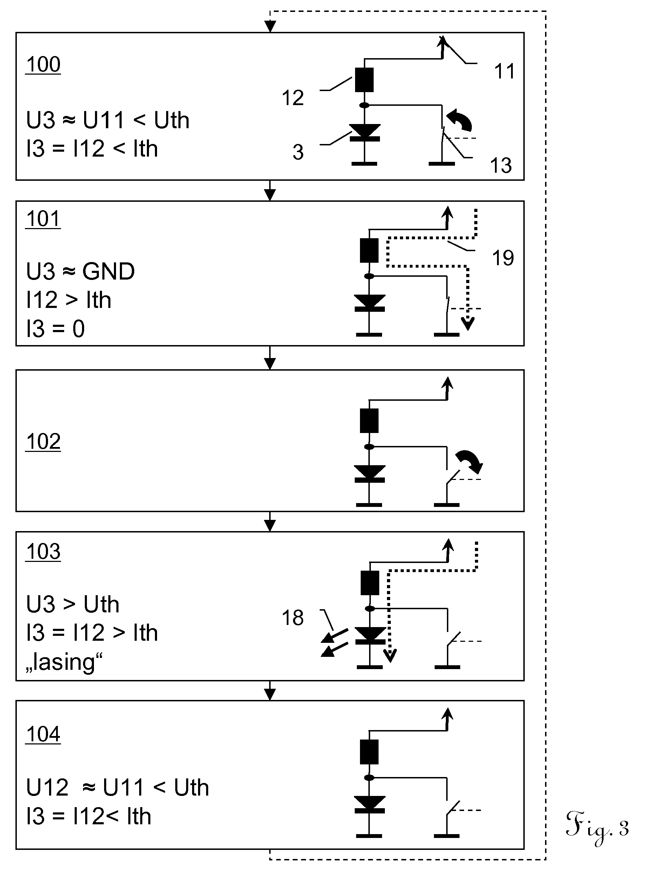

Die Schaltung ist zur Abgabe von gepulster Laserstrahlung, insbesondere von Pulspaketen (Bursts), ausgelegt. In Fig. 3 ist ein beispielhaftes Ablaufschema der Laser-Pulsgeneration dargestellt. Die Bezugszeichen in den Elektroschemata bleiben jeweils gleich und sind aus Gründen der Übersichtlichkeit nur jeweils einmal dargestellt.

In Schritt 100 wird der Schalter 13 geschlossen. Kurz vor dem Schließen des Schalters 13 liegt die Versorgungsspannung V11, welche unter Laser Threshold-Spannung Vth liegt, an der Serienschaltung der Induktivität 13 und der Laserdiode 3 an. Durch die Laserdiode 3 und die Induktivität 12 fließt derselbe Strom 13 bzw. 112, welcher aufgrund der exponentiellen Strom-Spannungskennlinie der Laserdiode, unterhalb der Threshold-Spannung Uth (bzw. des Threshold-Stroms Ith) sehr gering ist. In der Laserdiode herrscht eine zu niedrige Besetzungsinversion, als das eine stimulierte Emission von Laserlicht möglich wäre.

Nach dem Schließen des Schalters 13 liegt die Versorgungsspannung V11, an der Induktivität 13 als Spannung V12 an.

Wie in Schritt 101 dargestellt, baut sich ein Strom 19 in der Induktivität 12 als 112 nach der bekannten

$$1 - e^{-\frac{t}{\iota}}$$

Funktion auf, welcher über den Schalter 13 abfließt. Die Laserdiode 3 ist dabei kurzgeschlossen und sowohl Spannung U3 als auch Strom 13 sind praktisch Null. Somit kann kein Licht emittiert werden.

In Schritt 102 wird der Schalter 13 geöffnet.

Wie in Schritt 103 gezeigt, fließt nunmehr der Strom 19 aufgrund der Stetigkeitsbedingung in der Induktivität 12 weiter, nunmehr aber als 13 über die Laserdiode 3 statt über den nun geöffneten Schalter 13. Die Spannung U3 über der Laserdiode 3 erhöht sich entsprechend über jene der Laserschwelle - die Laserdiode emittiert Laserlicht, welches durch die nunmehr vorhandenen Pfeile 18 symbolisiert wird.

Da der Strom nunmehr - nach einer

$$e^{-\frac{t}{\iota}}$$

Funktion - abklingt bis der Gleichgewichtszustand erreicht ist, bei welchem der Spannungspegel U12 in etwa der Versorgung U11 entspricht - also unter der Laserschwelle Uth liegt und entsprechend der Strom 13 durch die Laserdiode 3 unter den zugehörigen Schwellenstrom Ith gefallen ist. Nun wird auch kein Laserlicht 18 mehr emittiert.

Die Schaltzeitpunkte des Schalters 13 können dabei frei von der Pulsgenerator-Schaltung 14 gewählt werden, also beispielsweise auch während des Aufbauens oder Abbauens des Stromes 19, wodurch beispielsweise die Pulsform und/oder die Pulsenergie variiert werden können.

Die Laserpulsgenerationsmethode oder Verfahren zur Erzeugung eines Laserpulses mittels einer Laserdiode, lässt sich in anderen Worten beschreiben mit:

- Einem Versorgen der Laserdiode über eine induktive Komponente mit einer Versorgungsspannung, welche unterhalb einer Laserthreshold-Spannung der Laserdiode liegt;
- Einem Aufbauen eines Stromes durch die induktive Komponente durch Schließen eines parallel zur Laserdiode angeordneten Schaltelements;
- einem Abbauen des Stromes über die Laserdiode unter Emission des Laserpulses bei Öffnen des Schaltelements.

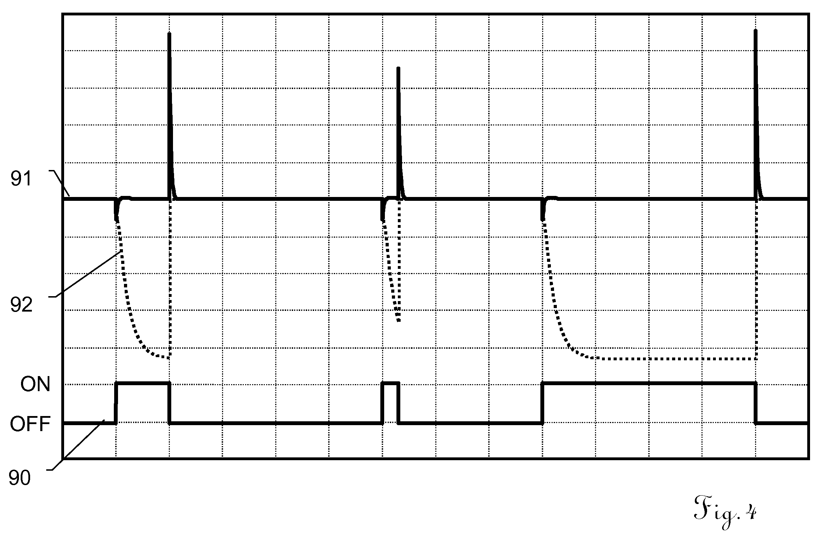

Das Diagramm in Fig. 4 zeigt beispielhafte Stromverläufe an der Laserdiode 3 als Graph 91 (durchgezogene Linie) und an der induktiven Komponente 12 als Graph 92 (punktierte Linie). Die induktive Komponente kann beispielsweise als gewickelte Spule, als ein entsprechend geformter Leiterbahnabschnitt oder als SMD-Induktivität ausgeführt sein. Eine Ausführung der induktiven Komponente in Form induktiven Übertragers, beispielsweise ähnlich der Grundstruktur eines Flyback-Konverters mit der Laserdiode als Last, kann ebenfalls als eine Sonderform zur Erzeilung der Lasersicherheit ohne Monitordiode herangezogen werden. Der Graph 90 zeigt den Zustand des Schalters 13, wobei ON für geschlossen und OFF für offen steht. Es ist deutlich ersichtlich, dass in beiden statischen Schaltzuständen der Diodenstrom Null oder jedenfalls unter der Laserschwelle liegt. Lediglich nach dem Öffnen des Schalters fließt der Strom, welcher zuvor durch die Induktivität geflossen ist aufgrund der Stetigkeitsbedingung der induktiven Komponente über die Laserdiode 3, bis sich dieser abgebaut hat bzw. bis der Schalter 13 wieder geschlossen wird. Wie beim zweiten Puls dargestellt lässt sich die Pulsenergie auch durch eine kürzere Einschaltzeit des Schalters 13, in welcher der Strom durch die Induktivität 12 noch nicht den Sättigungswert erreicht hat, variieren. Im Gegensatz zu einem Ansatz der Pulsenergievariation mit im Ruhezustand geschlossenem Schalter, fließt hierbei pro Puls in Summe weniger Strom, was sich positiv auf die Energieeffizienz der Schaltung auswirkt. Gegebenenfalls ist bezüglich der Lasersicherheit aber in beiden Fällen die maximal mögliche Pulsenergie bei einem Fehlerfall eines zu langsam getakteten Schalters 13 zu beachten oder ein Auftreten eines solchen Fehlers durch weitere Maßnahmen entsprechend zu verhindern. Insbesondere wenn die induktive Komponente als ein Pulsformungsnetzwerk ausgeführten wird, kann die Form des erzeugten optischen Pulses bei Variation der Einschaltdauer des Schalters zumindest annähernd gleich gehalten werden und primär nur sein Spitzenwert und somit auch die Pulsenergie variiert werden, wie dies auch der zweite Puls des Graphen 92 bzw. 92 illustriert. Der dritte dargestellte Puls zeigt eine Sättigung der induktiven Komponente, welche die maximal erreichbare Pulsenergie limitiert. Die induktive Zeitkonstante beschränkt dabei die maximal mögliche Puls-Repetitionsrate.

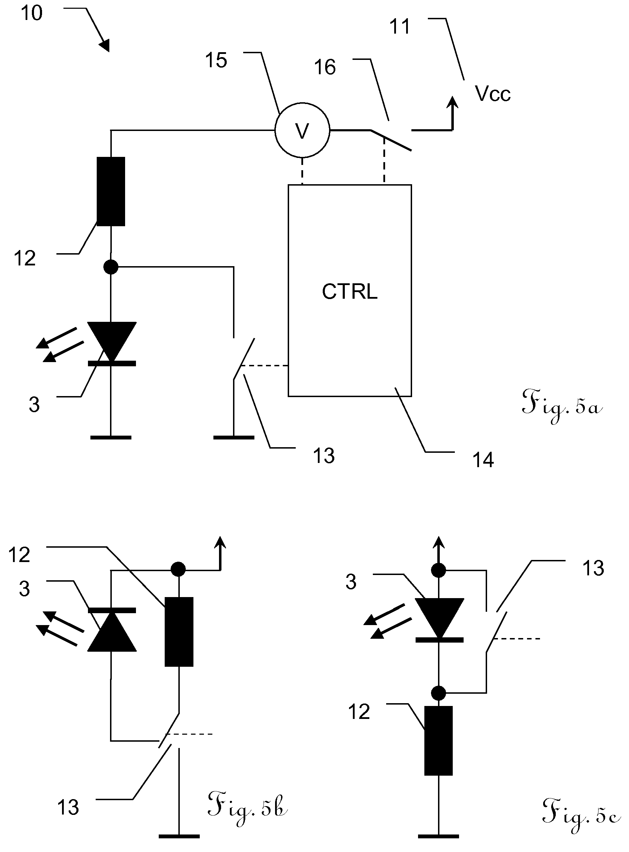

In Fig. 5a ist eine Ausführungsform dargestellt, bei welcher zur Erweiterung der Sicherheit zusätzlich eine Überwachung 15 der Laser-Versorgungsspannung auf eine allfällige Threshold-Überschreitung vorgenommen wird. Falls in einem elektrischen Netz der Laserdiodenversorgung eine Spannung, welche über dem Laserthrehold liegt festgestellt wird, so wird eine entsprechende Maßnahme ergriffen um eine Emission von Laserlicht zu verhindern. Die beispielhaft dargestellten Maßnahmen sind entweder ein Schließen des Schalters 13, wodurch die Laserdiode 3 kurzgeschlossen wird und zusätzlich - oder als Alternative - ein Trennen der Versorgung 11 über einen weiteren, unabhängigen Schalter 16. Das Trennen der Versorgung kann dabei das gesamte Lasersystem, den Lasertreiber 10 oder die Laserdiode 3 betreffen. Bezüglich der konkreten Anordnung des weiteren Schalters 16 zur Sicherheitsabschaltung sind dem Fachmann noch weitere - funktionell äquivalente-Möglichkeiten bekannt, beispielsweise ein Lowside-Switch im unteren Zweig der Laserdiode, etc. So kann etwa neben der Nutzung des Schaltelements 13 auch ein weiteres Schaltelement 16 zum Kurzschluss der Laserdiode 3, also parallel zum Schaltelement 13, angeordnet sein, sodass in dessen geschlossenem Zustand kein Laserlicht 18 emittierbar ist, insbesondere kann das weitere Schaltelement 16 anhand der Detektion der Spannungsüberwachungsschaltung 15 angesteuert sein.

Eine derartige Ausführungsform erlaubt auch das Vorhandensein von Spannungen über der Laserthreshold-Spannung im Gerät oder auf dem Lasertreiber. Selbst im Fehlerfall eines Kurzschlusses der kritischen Versorgungsspannung zu einem elektrischen Netz der Laserdiode genügt die Schaltung dabei den Sicherheitsvorschriften. Beispielsweise falls auf derselben Leiterplatte Logikelemente, ein Prozessor, Kommunikationsbausteine, etc. vorhanden sind, welche mit einem Pegel von bspw. 2.5V, 3.3V, 5V oder 12V arbeiten, welcher über der Threshold-Spannung, beispielsweise von 1.8V bis 2.2V bei Infrarot-Laserdioden, liegt.

Erfindungsgemäß wird die höhere Spannung dabei zur Versorgung der Laserdiode in bekannter Weise mit einem linearen oder getakteten Spannungsregler entsprechend heruntergesetzt.

In Fig. 5b und Fig. 5c sind zwei Beispiele von alternativen Anordnungen der Komponenten mit welchen einen erfindungsgemäß arbeitender Laserdiodentreiber ausgeführt werden kann dargestellt, wobei dem Fachmann noch weitere Alternativen zur Komponentenanordnung bekannt sind mit welchen sich das erfindungsgemäße Prinzip realisieren lässt.

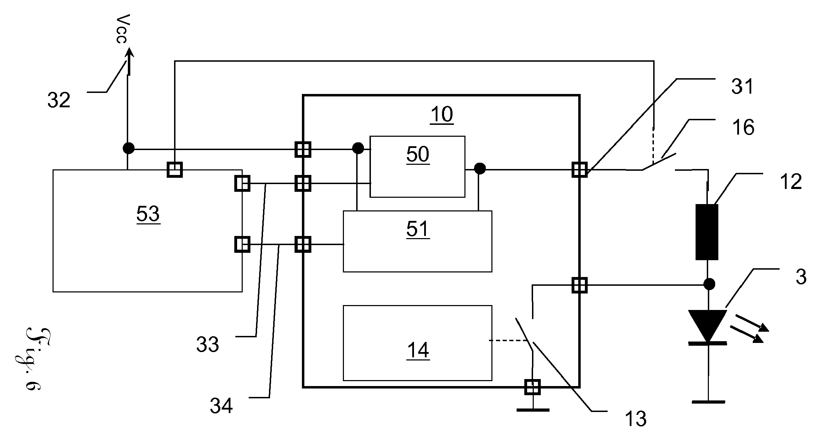

Fig. 6 zeigt ein Blockschaltbild eines Systems mit einem Kontroll- bzw. Kommunikationsprozessor 53, und einem Lasertreiber 10, welcher die Laserdiode 3 zur Emission von Lichtpulsen ansteuert. Der Prozessor 53 und der Lasertreiber 10 sind dabei von einer Systemversorgung 11, welche über dem Laserthreshold-Pegel liegt, versorgt.

In diesem Ausführungsbeispiel ist der Lasertreiber 10 beispielhaft als ASIC ausgeführt. Ein Längsregler 50 (z.B. ein LDO) im Lasertreiber-ASIC 10 versorgt den Laserdiodenausgang 31 mit einer konstanten, von der Systemspannung 32 unabhängigen Spannung, die unter der Laserthreshold-Spannung liegt.

Ein Fehlerfall bei welchem ein Kurzschluss zwischen Systemspannung 32 und dem Laserdiodenausgang 31 auftritt, wird durch die eingebaute Kurzschluss-Detektions-Schaltung 51 (SCD) erkannt und mittels eines digitalen Fehlersignals 33 an den Prozessor oder Mikrokontroller 53 signalisiert, beispielsweise über ein digitales Signal oder über einen Kommunikationskanal. Der übergeordnete Controller 53 kann die nun zu hohe Vorwärtsspannung über das Schaltelement 16 von der Spule 12 und der Laserdiode 3 trennen. Allenfalls kann eine solche Trennung auch direkt durch das Fehlersignal 33 ausgelöst werden. Anders gesagt wird die Trennung der Laserdiode 3 durch den Schalter 16 nur aufgehoben, falls die Spannung am Laserdiodenausgang 31 im sicheren Bereich unterhalb der Laserschwelle liegt.

In der dargestellten Ausführungsform verfügt der LDO zusätzlich über einen Freigabe-Eingang 34, welcher zusätzlich die Bereitstellung der Laserversorgungsspannung unterbindet bzw. erlauben kann. Dieser kann als weiterführende Sicherheitsschaltung zur Verhinderung einer unerwünschten Emission genutzt werden.

Weiters im beispielhaften Lasertreiber-Asic enthalten ist der Puls-Generator 14, welcher den Schalter 13 ansteuert und die Pulsfolge (z.B.: Ein-Zeit, Aus-Zeit, Puls-Repetitionsrate, Puls-Tastverhältnis, Burst-Tastverhältnis, Burst-Repetitionsrate, Pulse per Burst, etc.) bestimmt. Dieser kann über eine Kommunikationsschnittstelle (beispielsweise Eindraht-, SSI, SPI, I2C, UART, ...) anstelle oder zusätzlich zu den Leitungen 33/34 vom übergeordneten Controller 53 aus konfiguriert und ausgelöst werden. Die Ansteuerung des Schalters 13, welcher in dieser Darstellung ebenfalls im ASIC 10 integriert ist, kann beispielsweise als ein (beliebig konfigurierbares) PWM-Signal zur Erzeugung der gewünschten Ausgangspulsfolge realisiert werden.

Der Schalter 13, beispielsweise ein MOSFET-Transistor-Ausgang, ist mit der Laserdiode in der zuvor beschriebenen weise verbunden.

Falls die durch die Schaltung erzielte Pulsform eines emittierten Laser-Pulses nicht den Erfordernissen der Anwendung entspricht, so kann diese auf verschiedenste Weise angepasst werden. Zum einen bestimmt sich die Pulsform aus den Kennzahlen der induktiven Komponente (speziell aus dem Induktivitätswert, aber auch aus den parasitären Parametern, wie Serienwiderstand, etc.). In weiterer Folge kann die Induktivität auch durch ein komplexeres Puls-Formungs-Netzwerk ersetzt oder ergänzt werden, beispielsweise durch parallel und/oder Serienanordnung von Widerständen und/oder Kondensatoren (wobei funktionsbedingt der grundsätzlich induktive Charakter erhalten bleiben muss). Ein solches Puls-Formungs-Netzwerk kann beispielsweise auch in den GND-Zweig der Laserdiode eingebracht werden.

Zudem kann auch durch eine entsprechende Ansteuerung des Schaltelements 13 die Pulsform angepasst werden, beispielsweise kann durch erneutes Einschalten des Schalters 13 noch während der Pulsemission, das Ende des Pulses "abgeschnitten" werden, und somit die Pulsform mehr zu einem Rechteck getrimmt werden. Über die Pulsbreite (bestimmt durch die OFF-Zeit und/oder ON-Zeit des Schalters 13) kann auch die Ausgangsleistung eines Pulses eingestellt werden. Bei entsprechend schnellem Pulsgenerator kann auch eine PWM-Modulation innerhalb eines Pulses erreicht werden, wodurch, insbesondere bei entsprechender Glättung der PWM Modulation innerhalb des Pulses durch das Pulsformungsnetzwerk, die Form des emittierten Pulses (Intensitätsprofil über der Zeit) und/oder die Pulsenergie konfigurierbar ist.

Ein Lasertreiber, wie er in dieser Ausführungsform dargestellt ist, lässt sich zudem in hoch integrierter Form herstellen, beispielsweise in Dickschichttechnik, Dünnschichttechnik oder als ASIC, wobei eine reduzierte Baugrösse auch Vorteile bezüglich der elektromagnetischen Störaussendung bringt. Zudem lässt sich die Anzahl der erforderlichen externen Anschlüsse auf die obligatorischen Versorgungsanschlüsse, zwei Laserdiodenausgänge, sowie einer Kommunikationsschnittstelle zum übergeordneten Prozessor (bspw. als Zweileiterkommunikation), gegebenenfalls mit einem Freigabe-Eingang und einem Fehler-Ausgang reduzieren. Falls es die Anwendung erfordert kann zudem noch ein Auslöse-, Takt-, und/oder Phasenreferenzsignal für den Pulsgenerator 14 hinzukommen.

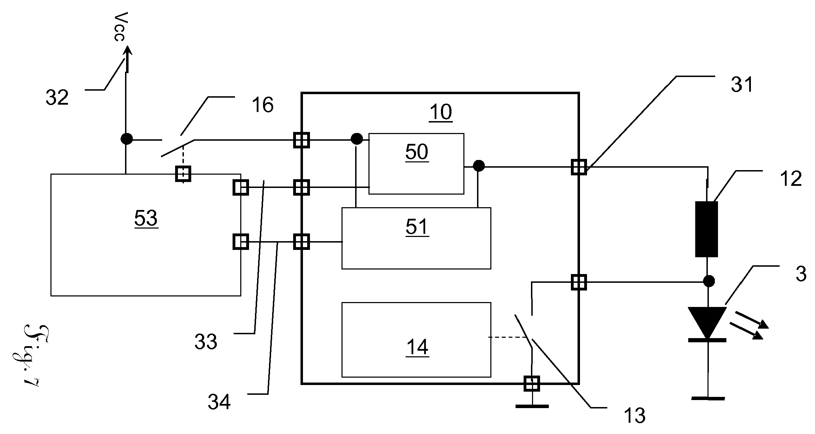

Fig. 7 zeigt eine Alternative der vorherigen Schaltung bei welcher im Fehlerfall die Versorgungsspannung des ganzen Lasertreibers durch einen Schalter 16 von der Systemspannung getrennt wird. In einer weiteren Ausführungsform kann gegebenenfalls der Schalter 16 auch in den Lasertreiber 10 integriert sein. Auch eine Integration des Prozessors 53 in einen als ASIC ausgeführten Lasertreiber wäre möglich.

Die hier beschriebene erfindungsgemäße Schaltung bzw. Methode eignet sich beispielsweise in hohem Masse für einen Laserentfernungsmesser mit Burst-Modulierter Laserstrahlung, nach dem Prinzip wie dies beispielsweise in EP 01 957 668 beschrieben ist. Erfindungsgemäß können dabei ohne Verwendung einer Monitordiode die Kriterien der Lasersicherheit eingehalten werden, wodurch sich ein kompakteres, kostengünstigeres und weniger komplexes Gesamtsystem ergibt. Ein derartiger Distanzmesser weist eine Sendeinheit zur Aussendung der Laserlichtpulse 18 mit dem Lasertreiber

10 und der Laserdiode 3, eine Empfangseinheit zum Empfang eines zurückgeworfenen Anteils der Laserlichtpulse 18 mit einem photoempfindlichen elektronischen Bauelement und eine Auswerteeinheit zur Bestimmung einer Distanz zu einem Zielobjekt anhand einer Laufzeit der Laserlichtpulse 18 vom Distanzmesser zu dem Zielobjekt und zurück auf.

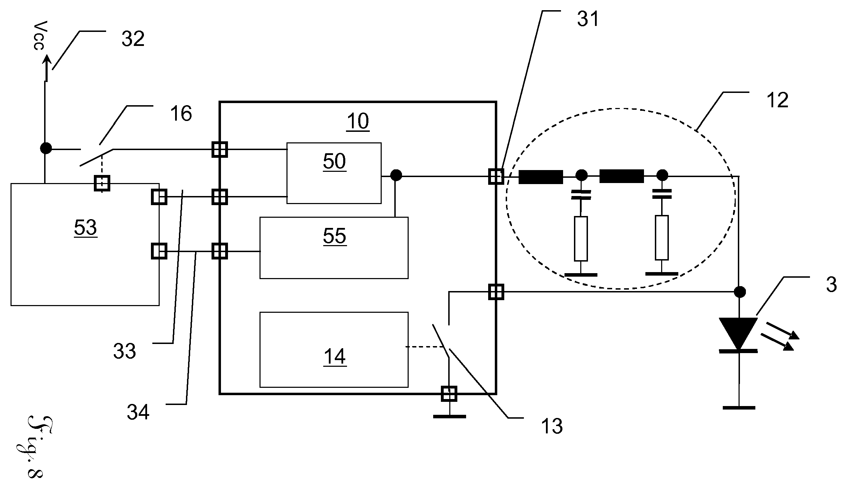

Fig. 8 stellt die bereits erwähnte Spannungsüberwachung mittels eines Komparator-Bauelements 55 dar. Der Komparator 55 vergleicht die Spannung 31 mit einem maximal zulässigen Wert, welcher unter der Laserschwellenspannung liegt, und gibt bei einer Überschreitung ein digitales Fehlersignal 34 aus, aufgrund welchem eine weitere Zufuhr von Versorgungsenergie verhindert wird, beispielsweise durch den gezeigten Schalter 16. In dieser Figur ist die induktive Komponente 12 in Form eines beispielhaften Puls-formungs-Netwerks ausgeführt, wie dies bereits weiter oben erläutert wurde. Das gezeigte Beispiel weist durch die beiden Induktivitäten zwar eine grundsätzlich induktive Charakteristik auf, jedoch wird durch die weiteren Komponenten die Form des erzeugbaren Strom/Spannungs-Pulses beeinflusst. Im speziellen können Flankensteilheit und/oder Spitzenwerte der elektrischen Pulses beeinflusst werden, etwa um den Schalter 13 vor Überlastung zu schützen oder den optischen Puls in seinem zeitlichen Verlauf anzupassen. Eine Variation und/oder Auslegung des hier beispielhaft gezeigten Pulsformungsnetzwerkes zur Erfüllung der anwendungsspezifischen Anforderungen ist dem Fachmann geläufig oder kann durch eine Simulation oder Versuchsaufbauten ermittelt werden.

**Patentansprüche**

1. Elektrooptischer Distanzmesser mit einem Lasertreiber (10) für eine Laserdiode (3) zur Emission von Laserlichtpulsen (18) mit:

   • einer Laserdioden-Spannungversorgung (11,31) mit einem Spannungsregler (50), welcher zum Heruntersetzen einer Systemspannung (32) zu einer Spannung unterhalb einer Laser-Threshold-Spannung der Laserdiode (3) ausgebildet ist,
   • einer induktiven Komponente (12) in einem Versorgungspfad der Laserdiode (3), insbesondere verbunden mit der Laserdiode (3), im Speziellen im Schaltkreis zwischen der Spannungsversorgung (11,31) und der Laserdiode (3) liegend, und
   • einem elektronischen Schaltelement (13), insbesondere parallel zur Laserdiode (3), welches derart zusammenwirkend angeordnet ist, dass

      ☐ in einer ersten Schaltstellung des Schaltelements (13) ein Stromfluss (19) durch die induktive Komponente (12) erzeugbar ist und
☐ in einer zweiten Schaltstellung des Schaltelements (13) der Stromfluss (19) durch die Laserdiode (3) leitbar ist,

wobei durch Wechsel von der ersten zur zweiten Schaltstellung einer der Laserlichtpulse (18) emittierbar ist und in der statischen ersten sowie der statischen zweiten Schaltstellung kein Laserlicht emittierbar ist.

2. Distanzmesser nach Anspruch 1, **gekennzeichnet durch** eine Spannungsüberwachungsschaltung (15,51,55) der Laserdioden-Spannungsversorgung (11,31) zur Detektion eines Wertes der Spannung welcher über einer vorgegebenen Grenze, insbesondere über der Laser-Threshold-Spannung, liegt, im Speziellen mittels eines Spannungs-Komparators (55).

3. Distanzmesser nach Anspruch 2, **dadurch gekennzeichnet, dass** die Spannungsüberwachungsschaltung (15,51,55) durch eine Kurzschluss-Detektions-Schaltung des Spannungsreglers (50), insbesondere eines Tiefsetzstellers, im Speziellen eines Low Drop-Out Längsreglers, erfolgt.

4. Distanzmesser nach einem der Ansprüche 1 bis 3, **gekennzeichnet durch** ein weiteres Schaltelement (16) zur Trennung des Versorgungspfades der Laserdiode oder des gesamten Lasertreibers (10) sodass kein Laserlicht (18) emittierbar ist, insbesondere wobei das weitere Schaltelement (16) anhand der Detektion der Spannungsüberwachungsschaltung (15,51) angesteuert wird.

5. Distanzmesser nach einem der Ansprüche 2 bis 3, **gekennzeichnet durch** ein weiteres Schaltelement (16) zum Kurzschluss der Laserdiode (3) sodass in dessen geschlossenem Zustand kein Laserlicht (18) emittierbar ist, insbesondere wobei das weitere Schaltelement (16) anhand der Detektion der Spannungsüberwachungsschaltung (15,51) angesteuert wird.

6. Distanzmesser nach einem der Ansprüche 1 bis 5, **dadurch gekennzeichnet, dass** die induktive Komponente (12) in Form eines Puls-Formungs-Netzwerks zur Formung der emittierten Laserlichtpulse (18) ausgeführt ist, insbesondere wobei dieses ein dominant induktives Verhalten zeigt.

7. Distanzmesser nach einem der Ansprüche 1 bis 6, **dadurch**

**gekennzeichnet, dass**
das Schaltelement (13) zur Laserpulsemission von einer konfigurierbaren Pulsweitenmodulations-Einheit (14) angesteuert wird, insbesondere wobei durch die Pulsweitenmodulation die Energie des Laserlichtpulses (18) und/oder ein Intensitätsprofil des Laserlichtpulses (18) konfigurierbar ist.

8. Distanzmesser nach einem der Ansprüche 1 bis 7, **dadurch gekennzeichnet, dass**
der Lasertreiber (10) mit Ausnahme der Laserdiode (3) und der induktiven Komponente (12) als ASIC, insbesondere mit einem rein digitalen Ansteuerungs-Interface, ausgeführt ist.

9. Distanzmesser nach einem der Ansprüche 1 bis 8, mit einer Sendeinheit zur Aussendung der Laserlichtpulse (18) mit dem Lasertreiber (10) und der Laserdiode (3),
einer Empfangseinheit zum Empfang eines zurückgeworfenen Anteils der Laserlichtpulse (18) mit einem photoempfindlichen elektronischen Bauelement und einer Auswerteeinheit zur Bestimmung einer Distanz zu einem Zielobjekt anhand einer Laufzeit der Laserlichtpulse (18) vom Distanzmesser zu dem Zielobjekt und zurück,
insbesondere wobei die Laserlichtpulse (18), als burstartige Laserpulspakete emittiert werden.

10. Verfahren zur Erzeugung eines Laserpulses (18) mittels einer Laserdiode (3) in einem elektrooptischen Distanzmesser, **gekennzeichnet durch**

   • ein Heruntersetzen einer Systemspannung (32) mit einem Spannungsregler (50) zu einer Versorgungsspannung (11,31), welche unterhalb einer Laserthreshold-Spannung der Laserdiode (3) liegt,
   • ein Versorgen der Laserdiode (3) über eine induktive Komponente (12) mit der Versorgungsspannung (11,31),
   • ein Aufbauen eines Stromes (19) **durch** die induktive Komponente (12) **durch** Schließen eines parallel zur Laserdiode angeordneten Schaltelements (13),
   • ein Abbauen des Stromes über die Laserdiode (3) unter Emission des Laserpulses (18) **durch** Öffnen des Schaltelements (13).

11. Verfahren nach Anspruch 10, **gekennzeichnet durch,**
ein detektieren eines Fehlerfalls **durch** ein überwachen der Versorgungsspannung (11,31) auf erreichen oder übersteigen einer vorgegebenen Spannungsgrenze, insbesondere der Laserthreshold-Spannung.

12. Verfahren nach Anspruch 11, **gekennzeichnet durch,**
ein Trennen der oder Kurzschließen der Laserdiode (3) mittels eines weiteren Schaltelements (16) im Fehlerfall.

13. Verfahren nach einem der Ansprüche 11 oder 12, **dadurch gekennzeichnet, dass,**
das Überwachen durch eine Kurzschlussdetektion an der die Versorgungsspannung herabsetzenden Spannungsregler-Schaltung (50) erfolgt, insbesondere an einem herabsetzenden Festspannungsregler.

14. Verfahren zum Pulsbetrieb einer Laserdiode eines elektrooptische Distanzmessers an einer Versorgungsspannung welche unter der Laserthreshold-Spannung liegt nach einem der Ansprüche 10 bis 13, wobei in Serie zur Laserdiode die induktive Komponente angeordnet ist und mit dem parallel zur Laserdiode angeordneten Schaltelement die Laserdiode kurzschließbar ist.

15. Verfahren zur monitordiodenlosen Sicherstellung einer Einfachfehlersicherheit in einem Laserdiodentreiber (10) in einem elektrooptischen Distanzmesser mittels des Verfahrens nach einem der Ansprüche 10 bis 14.

**Claims**

1. An electro-optical distance measuring device comprising a laser driver (10) for a laser diode (3) for emitting laser light pulses (18) comprising:

   • a laser diode voltage supply (11, 31) with a voltage regulator (50) being adapted for reducing a system voltage (32) to a voltage below a laser threshold voltage of the laser diode (3),
   • an inductive component (12) in a supply path of the laser diode (3), in particular connected to the laser diode (3), especially in the circuit between the voltage supply (11, 31) and the laser diode (3), and
   • an electronic switching element (13), in particular in parallel with the laser diode (3), which electronic switching element is arranged interactively in such a way that

      □ in a first switching position of the switching element (13), a current flow (19) through the inductive component (12) can be produced, and
      □ in a second switching position of the switching element (13), the current flow (19) can be conducted through the laser diode (3),

wherein, by changing from the first to the second switching position, one of the laser light pulses (18) can be emitted and, in the steady-state first and the steady-state second switching positions, no laser light can be emitted.

2. The distance measuring device as claimed in claim 1, **characterized by**
a voltage monitoring circuit (15, 51, 55) of the laser diode voltage supply (11, 31) for detecting a value of the voltage which is above a predetermined limit, in particular above the laser threshold voltage, especially by means of a voltage comparator (55).

3. The distance measuring device as claimed in claim 2, **characterized in that**
the voltage monitoring circuit (15, 51, 55) is effected by a short-circuit detection circuit of the voltage regulator (50), in particular a step-down converter, especially a low-dropout series regulator.

4. The distance measuring device as claimed in any one of claims 1 to 3,
**characterized by**
a further switching element (16) for isolating the supply path of the laser diode or the entire laser driver (10) such that no laser light (18) can be emitted, in particular wherein the further switching element (16) is actuated on the basis of the detection of the voltage monitoring circuit (15, 51).

5. The distance measuring device as claimed in any one of claims 2 to 3,
**characterized by**
a further switching element (16) for short-circuiting the laser diode (3) with the result that, in the closed state of said switching element, no laser light (18) can be emitted, in particular wherein the further switching element (16) is actuated on the basis of the detection of the voltage monitoring circuit (15, 51).

6. The distance measuring device as claimed in any one of claims 1 to 5, **characterized in that** the inductive component (12) is in the form of a pulse-shaping network for shaping the emitted laser light pulses (18), in particular wherein said pulse-shaping network demonstrates a dominantly inductive response.

7. The distance measuring device as claimed in any one of claims 1 to 6, **characterized in that** the switching element (13) for laser pulse emission is actuated by a configurable pulse-width modulation unit (14), in particular wherein the energy of the laser light pulse (18) and/or an intensity profile of the laser light pulse (18) can be configured by the pulse width modulation.

8. The distance measuring device as claimed in any one of claims 1 to 7, **characterized in that** the laser driver (10), with the exception of the laser diode (3) and the inductive component (12), is embodied as an ASIC, in particular with a purely digital actuation interface.

9. The distance measuring device as claimed in any one of claims 1 to 8, comprising
a transmission unit for emitting the laser light pulses (18) with the laser driver (10) and the laser diode (3),
a reception unit for receiving a rejected component of the laser light pulses (18) with a photosensitive electronic component and
an evaluation unit for determining a distance from a target object on the basis of a propagation time of the laser light pulses (18) from the distance measuring device to the target object and back again,
in particular wherein the laser light pulses (18) are emitted as burst-like laser pulse packets.

10. A method for generating a laser pulse (18) by means of a laser diode (3) in an electro-optical distance measuring device, **characterized by**

    • reducing a system voltage (32), by a voltage regulator (50), to a voltage supply (11, 31) which is below a laser threshold voltage of the laser diode (3),
    • supplying the supply voltage (11, 31) to the laser diode (3) via an inductive component (12),
    • building up a current (19) through the inductive component (12) by closing a switching element (13) arranged in parallel with the laser diode,
    • decreasing the current across the laser diode (3) whilst emitting the laser pulse (18) by opening the switching element (13).

11. The method as claimed in claim 10, **characterized by**
detecting a fault case by monitoring the supply voltage (11, 31) to ascertain whether a predetermined voltage limit, in particular the laser threshold voltage, has been reached or exceeded.

12. The method as claimed in claim 11, **characterized by**
isolating or short-circuiting the laser diode (3) by means of a further switching element (16) in the event of a fault.

13. The method as claimed in either of claims 11 and 12, **characterized in that**
the monitoring is performed by short-circuit detection at the voltage regulator (50) which reduces the supply voltage, in particular at a step-down fixed voltage regulator.

14. A method for pulsed operation of a laser diode of an electro-optical distance measuring device using a supply voltage which is below the laser threshold voltage as claimed in any one of claims 10 to 13, wherein the inductive component is arranged in series with the laser diode, and the laser diode can be short-circuited by the switching element arranged in parallel with the laser diode.

15. A method for ensuring single-fault failsafety without the use of monitor diodes in a laser diode driver (10) in an electro-optical distance measuring device by means of the method as claimed in any one of claims 10 to 14.

**Revendications**

1. Dispositif de mesure de distance électro-optique avec un excitateur de laser (10) pour une diode laser (3) pour l'émission d'impulsions de lumière laser (18) avec :

   • une alimentation en tension pour diodes laser (11, 31) avec un régulateur de tension (50) qui est configuré pour abaisser une tension du système (32) à une tension au-dessous d'une tension de seuil laser de la diode laser (3),
   • un composant inductif (12) dans un trajet d'alimentation de la diode laser (3), en particulier lié à la diode laser (3), en particulier situé dans le circuit entre la tension d'alimentation (11, 31) et la diode laser (3), et
   • un élément de commutation électronique (13), en particulier parallèle à la diode laser (3), qui est placé en coopérant de telle manière

      □ qu'un flux de courant (19) peut être généré par le composant inductif (12) dans une première position de commutation de l'élément de commutation (13) et
      □ que le flux de courant (19) peut être guidé par la diode laser (3) dans une seconde position de commutation de l'élément de commutation (13),

   cependant que l'une des impulsions de lumière laser (18) peut être émise par le changement de la première à la seconde position de commutation et qu'aucune lumière laser ne peut être émise dans la première position statique de commutation ainsi que dans la seconde position statique de commutation.

2. Dispositif de mesure de distance selon la revendication 1, **caractérisé par** un circuit de surveillance de tension (15, 51, 55) de l'alimentation en tension pour diodes laser (11, 31) pour la détection d'une valeur de la tension qui se situe au-dessus d'un seuil prédéfini, en particulier au-dessus de la tension de seuil laser, en particulier au moyen d'un comparateur de tension (55).

3. Dispositif de mesure de distance selon la revendication 2, **caractérisé en ce que** le circuit de surveillance de tension (15, 51, 55) est réalisé par un circuit de détection de court-circuit du régulateur de tension (50), en particulier d'un abaisseur, en particulier d'un régulateur longitudinal à faible chute de tension.

4. Dispositif de mesure de distance selon l'une des revendications 1 à 3, **caractérisé par** un autre élément de commutation (16) pour la séparation du trajet d'alimentation de la diode laser ou de tout l'excitateur de laser (10) si bien qu'aucune lumière laser (18) ne peut être émise, en particulier cependant que l'autre élément de commutation (16) est excité à l'aide de la détection du circuit de surveillance de tension (15, 51).

5. Dispositif de mesure de distance selon l'une des revendications 2 à 3, **caractérisé par** un autre élément de commutation (16) pour le court-circuit de la diode laser (3) si bien que, lorsqu'elle est à l'état fermé, aucune lumière laser ne peut être émise, en particulier cependant que l'autre élément de commutation (16) est excité à l'aide de la détection du circuit de surveillance de tension (15, 51).

6. Dispositif de mesure de distance selon l'une des revendications 1 à 5, **caractérisé en ce que** le composant inductif (12) est réalisé en forme de réseau de formation d'impulsions pour former les impulsions de lumière laser émises (18), en particulier cependant que celui-ci montre un comportement inductif de manière dominante.

7. Dispositif de mesure de distance selon l'une des revendications 1 à 6, **caractérisé en ce que** l'élément de commutation (13) pour l'émission d'impulsions laser est excité par une unité de modulation de largeur d'impulsions (14) configurable, en particulier cependant que l'énergie de l'impulsion de lumière laser (18) et/ou un profil d'intensité de l'impulsion de lumière laser (18) peut être configurée par la modulation de largeur d'impulsions.

8. Dispositif de mesure de distance selon l'une des revendications 1 à 7, **caractérisé en ce que** l'excitateur de laser (10) est réalisé à l'exception de la diode laser (3) et du composant inductif (12) en tant qu'ASIC, en particulier avec une interface d'excitation purement numérique.

**9.** Dispositif de mesure de distance selon l'une des revendications 1 à 8 avec une unité d'émission pour émettre les impulsions de lumière laser (18) avec l'excitateur de laser (10) et la diode laser (3),
une unité de réception pour la réception d'une partie renvoyée des impulsions de lumière laser (18) avec un composant électronique photosensible et
une unité d'analyse pour déterminer une distance par rapport à un objet cible à l'aide d'une durée des impulsions de lumière laser (18) du dispositif de mesure de distance vers l'objet cible et retour, en particulier cependant que les impulsions de lumière laser (18) sont émises en tant que paquets d'impulsions laser en salve.

**10.** Procédé pour générer une impulsion laser (18) au moyen d'une diode laser (3) dans un dispositif de mesure de distance électro-optique, **caractérisé par**

• une baisse d'une tension du système (32) avec un régulateur de tension (50) à une tension d'alimentation (11, 31) qui se situe au-dessous d'une tension de seuil laser de la diode laser (3),
• une alimentation de la diode laser (3) par un composant inductif (12) avec la tension d'alimentation (11, 31),
• la constitution d'un courant (19) par le composant inductif (12) par la fermeture d'un élément de commutation (13) placé parallèlement à la diode laser,
• la suppression du courant par la diode laser (13) sous émission de l'impulsion laser (18) par l'ouverture de l'élément de commutation (13).

**11.** Procédé selon la revendication 10, **caractérisé par** une détection d'un cas de défaillance par une surveillance de la tension d'alimentation (11, 31) de l'atteinte ou du dépassement d'un seuil de tension prédéfini, en particulier de la tension de seuil laser.

**12.** Procédé selon la revendication 11, **caractérisé par** une séparation ou un court-circuit de la diode laser (3) au moyen d'un autre élément de commutation (16) en cas de défaillance.

**13.** Procédé selon l'une des revendications 11 ou 12, **caractérisé en ce que** la surveillance par une détection de court-circuit se fait sur le circuit du régulateur de tension (50) qui baisse la tension d'alimentation, en particulier sur un régulateur de tension fixe qui baisse la tension.

**14.** Procédé pour le fonctionnement pulsé d'une diode laser d'un dispositif de mesure de distance électro-optique sur une tension d'alimentation qui se situe au-dessous de la tension de seuil laser selon l'une des revendications 10 à 13, cependant que le composant inductif est placé en série avec la diode laser et la diode laser peut être court-circuitée avec l'élément de commutation placé parallèlement à la diode laser.

**15.** Procédé pour la sécurisation sans diode de moniteur d'une sécurité contre les erreurs simples dans un excitateur de diode laser (10) dans un dispositif de mesure de distance électro-optique au moyen du procédé selon l'une des revendications 10 à 14.

7

Vcc > Vth

CTRL

1

4

6

5

~

2

3

Fig. 1
Prior Art

10

Vcc < Vth

11

12

13

14

CTRL

3

Fig. 2

**100**

$U3 \approx U11 < Uth$

$I3 = I12 < Ith$

12

3

11

13

**101**

$U3 \approx GND$

$I12 > Ith$

$I3 = 0$

19

**102**

**103**

$U3 > Uth$

$I3 = I12 > Ith$

„lasing"

18

**104**

$U12 \approx U11 < Uth$

$I3 = I12 < Ith$

*Fig. 3*

*Fig. 4*

Fig. 5a

Fig. 5b

Fig. 5c

Fig. 6

Fig. 7

Fig. 8

**IN DER BESCHREIBUNG AUFGEFÜHRTE DOKUMENTE**

**In der Beschreibung aufgeführte Patentdokumente**

- EP 0314390 A
- US 5287375 A
- EP 0780937 A
- EP 0664591 A
- EP 0597644 A
- EP 01957668 A
- JP 7079042 A
- JP 2008227408 A
- US 7184130 B